# EUROPEAN PATENT APPLICATION

(11) **EP 4 512 772 A1**
(43) Date of publication of application: **26.02.2025**
(21) Application number: 23903744.3
(22) Date of filing: 01.11.2023
(51) Int. Cl.: C01B 33/113, C01B 33/18, C23C 16/26, H01M 4/36, H01M 4/38, H01M 4/48, H01M 4/40, H01M 4/62

(54) **METHOD FOR PREPARING NEGATIVE ELECTRODE ACTIVE MATERIAL, NEGATIVE ELECTRODE ACTIVE MATERIAL, NEGATIVE ELECTRODE, AND SECONDARY BATTERY**

(30) Priority: 16.12.2022 KR 20220177126; 31.10.2023 KR 20230147653
(71) Applicant: LG Energy Solution, Ltd., Seoul 07335 (KR)
(72) Inventor: HEO, Bumgi, Daejeon 34122 (KR); SHIN, Sun Young, Daejeon 34122 (KR); LEE, Su Min, Daejeon 34122 (KR); LEE, Yong Ju, Daejeon 34122 (KR)
(74) Representative: Hoffmann Eitle
(86) International application number: PCT/KR2023/017208
(87) International publication number: WO 2024/128541

(57) **Abstract**

The present invention relates to a method for preparing a negative electrode active material, a negative electrode active material, a negative electrode comprising same, and a secondary battery comprising same.

## Description

### [Technical Field]

The present invention relates to a method for manufacturing a negative electrode active material, a negative electrode active material, a negative electrode, and a secondary battery.

This application claims priority to and the benefit of Korean Patent Application No. 10-2022-0177126 filed in the Korean Intellectual Property Office on December 16, 2022, and Korean Patent Application No. 10-2023-0147653 filed in the Korean Intellectual Property Office on October 31, 2023, the entire contents of which are incorporated herein by reference.

### [Background Art]

Recently, with the rapid spread of electronic devices using batteries, such as mobile phones, laptop computers and electric vehicles, the demand for small, lightweight, and relatively high-capacity secondary batteries is rapidly increasing. In particular, a lithium secondary battery is in the limelight as a driving power source for portable devices because it is lightweight and has a high energy density. Accordingly, research and development efforts to improve the performance of a lithium secondary battery are being actively conducted.

In general, a lithium secondary battery includes a positive electrode, a negative electrode, a separator interposed between the positive electrode and the negative electrode, an electrolyte solution, an organic solvent, and the like. In addition, the positive electrode and the negative electrode may be formed on current collectors with active material layers each including a positive electrode active material and a negative electrode active material. In general, for the positive electrode, a lithium-containing metal oxide such as LiCoO₂ and LiMn₂O₄ is used as the positive electrode active material, and for the negative electrode, a carbon-based active material or a silicon-based active material that does not contain lithium is used as the negative electrode active material.

Among the negative electrode active materials, the silicon-based active material has attracted attention in that it has higher capacity than the carbon-based active material and excellent high-speed charge characteristics. However, the silicon-based active material has disadvantages in that a degree of volume expansion/contraction during charging and discharging is high, an irreversible capacity is high, and therefore, the initial efficiency is low.

On the other hand, among the silicon-based active materials, a silicon-based oxide, specifically, a silicon-based oxide represented by SiOₓ (0<x<2) has an advantage in that the degree of volume expansion/contraction during the charging and discharging is lower as compared with other silicon-based active materials such as silicon (Si).

In addition, a technology of forming a carbon layer is used to improve the conductivity of the negative electrode active material. However, with the general carbon layer manufacturing method, it is difficult to arrange the carbon layer uniformly on the surface of and inside the negative electrode active material, so the degree of improvement in the life performance of the battery is not significant.

Therefore, there is a need to develop a negative electrode active material in which a carbon layer is uniformly arranged on silicon-based particles and a method of manufacturing the negative electrode active material.

### Citation List

### Patent Literature

(Patent Literature 1) Korean Patent Application Publication No. 10-2019-0068476

### [Detailed Description of the Invention]

### [Technical Problem]

The present invention relates to a method for manufacturing a negative electrode active material, a negative electrode active material, a negative electrode including the negative electrode active material, and a secondary battery including the negative electrode.

### [Technical Solution]

An exemplary embodiment of the present invention provides a method for manufacturing a negative electrode active material, the method including: vaporizing a silicon-based precursor and an ionic compound by heat treatment; forming a silicon-based particle by depositing a mixed gas of the silicon-based precursor and the ionic compound together in a gas phase; and heat treating the silicon-based particle and a carbon source.

An exemplary embodiment of the present invention provides a negative electrode active material manufactured by the method for manufacturing a negative electrode active material.

An exemplary embodiment of the present invention provides a negative electrode active material including: a silicon-based particle including SiOₓ(0<x<2) and pores; and a carbon layer provided on a surface of and in the pores of the silicon-based particle, wherein the negative electrode active material includes one or more alkali metal elements selected from the group consisting of Li, Na, K, Rb, and Cs and one or more halogen elements selected from the group consisting of F, Cl, Br, and I, and wherein when analyzing a cross section of the negative electrode active material, an average diameter of the pores is 20 nm to 60 nm.

Another exemplary embodiment of the present invention provides a negative electrode including the negative electrode active material.

Still another exemplary embodiment of the present invention provides a secondary battery including the negative electrode.

### [Advantageous Effects]

The method for manufacturing a negative electrode active material according to an exemplary embodiment of the present invention deposits the silicon-based precursor and the ionic compound together to form the silicon-based particle, so that pores are evenly formed and the carbon layer is evenly arranged, thereby improving the conductivity of the negative electrode active material and improving the discharge capacity, initial efficiency, resistance performance, and/or life characteristics of the battery. In addition, the electrical conductivity of the negative electrode active material is further improved by the remaining ionic compound that has not been removed.

The negative electrode active material according to an exemplary embodiment of the present invention includes one or more alkali metal elements selected from the group consisting of Li, Na, K, Rb, and Cs and one or more halogen elements selected from the group consisting of F, Cl, Br, and I, and when analyzing a cross section of the negative electrode active material, the average diameter of the pores is 20 nm to 60 nm. The negative electrode active material having the above characteristics has the pores formed evenly and the carbon layer distributed evenly over a large area on the surface of the negative electrode active material and inside the pores, and includes the alkali metal element and halogen element, making it possible to improve the conductivity.

Accordingly, the negative electrode including the negative electrode active material according to an exemplary embodiment of the present invention, and the secondary battery including the negative electrode have effects of improving the discharge capacity, initial efficiency, resistance performance and/or life characteristics of the battery.

### [Best Mode]

Hereinafter, the present specification will be described in more detail.

In the present specification, when a part is referred to as "including" a certain component, it means that the part can further include another component, not excluding another component, unless explicitly described to the contrary.

Throughout the present specification, when a member is referred to as being "on" another member, the member can be in direct contact with another member or an intervening member may also be present.

It should be understood that the terms or words used throughout the specification should not be construed as being limited to their ordinary or dictionary meanings, but construed as having meanings and concepts consistent with the technical idea of the present invention, based on the principle that an inventor may properly define the concepts of the words or terms to best explain the invention.

As used herein, the singular forms "a", "an" and "the" are intended to include the plural forms as well, unless the context clearly indicates otherwise.

In the present specification, the crystallinity of the structure included in the negative electrode active material can be confirmed through X-ray diffraction analysis, and the X-ray diffraction analysis may be performed by using an X-ray diffraction (XRD) analyzer (product name: D4-endavor, manufacturer: Bruker), or by appropriately adopting devices that are used in the art, in addition to the above device.

In the present specification, the presence or absence of elements and the contents of elements in the negative electrode active material can be confirmed through ICP analysis, and the ICP analysis may be performed using an inductively coupled plasma atomic emission spectrometer (ICPAES, Perkin-Elmer 7300).

In the present specification, the average particle diameter (D₅₀) may be defined as a particle diameter corresponding to 50% of the cumulative volume in the particle size distribution curve of the particles (graph curve of the particle size distribution). The average particle diameter (D₅₀) may be measured using, for example, a laser diffraction method. In the laser diffraction method, in general, particle diameters ranging from a submicron region to several millimeters can be measured, and results with high reproducibility and high resolvability can be obtained.

In the present invention, a specific surface area of the silicon-based composite may be measured by the Brunauer-Emmett-Teller (BET) method. For example, the specific surface area may be measured with a BET six-point method by means of a nitrogen gas adsorption method using a porosimetry analyzer (Bell Japan Inc., Belsorp-II mini).

In the present invention, an average diameter of pores (size of the pores) may be measured by a calculation formula according to the BJH (Barrett-Joyer-Halenda) method through a nitrogen adsorption method. Specifically, a pore area according to the size of pores was derived using a BELSORP-mini II model manufactured by BEL Japan, Inc., and the size of pores showing the largest pore area was used as a representative pore size. The BJH method may be used, and in the plot of the measured values, the X-axis is the diameter of pores (Dp/nm) and the Y-axis is dVp/dDp (cm³g⁻¹nm⁻¹).

Hereinafter, preferred embodiments of the present invention will be described in detail. However, it should be understood that the embodiments of the present invention may be modified in various forms and the scope of the present invention is not limited to the embodiments described below.

### <Method for Manufacturing Negative Electrode Active Material>

An exemplary embodiment of the present invention provides a method for manufacturing a negative electrode active material, the method including: vaporizing a silicon-based precursor and an ionic compound by heat treatment; forming a silicon-based particle by depositing a mixed gas of the silicon-based precursor and the ionic compound together in a gas phase; and heat treating the silicon-based particle and a carbon source.

When forming the silicon-based particle by depositing the silicon-based precursor and the ionic compound together, the ionic compound is distributed in the silicon-based particle, and as the ionic compound is removed during the subsequent heat treatment, pores are evenly formed in the silicon-based particle, and at the same time, the carbon layer is evenly arranged over a large area on the surface of the silicon-based particle and/or inside the pores, thereby improving the conductivity of the negative electrode active material and improving the discharge capacity, initial efficiency, resistance performance, and/or life characteristics of the battery. In addition, the electrical conductivity of the negative electrode active material is further improved by the remaining ionic compound that has not been removed.

The silicon-based precursor may be one or more selected from the group consisting of Si powder, SiO powder, and SiO₂ powder, and preferably, may be a mixed powder of Si powder, SiO powder and SiO₂ powder.

After vaporizing the silicon-based precursor and the ionic compound by heat treatment in a vacuum, the vaporized mixed gas can be deposited together to form a silicon-based particle containing the ionic compound.

Specifically, the silicon-based precursor and the ionic compound can be vaporized by heat treatment at temperatures of 1800°C or higher and 2500°C or lower in an inert gas atmosphere. Specifically, the silicon-based precursor and the ionic compound can be vaporized by heat treatment at temperatures of 2200°C or higher and 2400°C or lower. At this time, the silicon-based precursor and the ionic compound may be vaporized from different sources and then mixed, or may be vaporized from the same source to form a mixed gas of the silicon-based precursor and the ionic compound.

The deposition may be performed in an inert gas atmosphere and at temperatures of 500°C or higher and 1000°C or lower. Specifically, the deposition may be performed by heat treatment (cooling) under conditions of 600°C or higher and 800°C or lower.

When manufacturing the negative electrode active material, the silicon-based precursor and the ionic compound are deposited together to manufacture the silicon-based particle. At this time, pores can be formed evenly in the silicon-based particle due to the ionic compound.

The ionic compound includes one or more alkali metal elements selected from the group consisting of Li, Na, K, Rb, and Cs and one or more halogen elements selected from the group consisting of F, Cl, Br, and I. Specifically, the ionic compound may exist by ionic bonding of the alkali metal element in the form of a cation and the halogen element in the form of an anion. Preferably, the halogen element is Cl, Br or I, and more preferably Cl.

In an exemplary embodiment of the present invention, the ionic compound may be one or more selected from the group consisting of LiF, LiCl, NaF, and NaCl.

The ionic compound may have a melting point of 600°C to 800°C and a boiling point of 1300°C to 1700°C.

In this case, the ionic compound is removed to form pores during the heat treatment of the silicon-based particle, and part of the ionic compound that has not been removed remains and is present in the negative electrode active material.

A weight ratio of the silicon-based precursor and the ionic compound may be 90:10 to 99.9:0.1, or 95:5 to 99:1.

When the negative electrode active material is manufactured by adding the ionic compound in the above content, an appropriate content of the ionic compound is added into the silicon-based particle, so that pores can be formed evenly later.

In an exemplary embodiment of the present invention, the silicon-based particle including the ionic compound formed during the deposition may be subjected to an additional heat treatment at temperature of 800°C to 1100°C.

During the additional heat treatment process, the ionic compound included in the silicon-based particle is appropriately removed, so that multiple pores can be evenly formed in the silicon-based particle. In addition, part of the ionic compound that has not been removed is included in the silicon-based particle, which further improves the electrical conductivity of the material.

The silicon-based particle formed as described above may include SiOₓ(0<x<2), an alkali metal element, and a halogen metal element. The alkali metal element and the halogen metal element are derived from the ionic compound that remains without being removed and may be distributed on the surface of and/or inside the silicon-based particle.

In an exemplary embodiment of the present invention, in order to dope the silicon-based particle with metal (for example, Li or Mg), the step of vaporizing the silicon-based precursor and the ionic compound by heat treatment may include vaporizing a metal precursor by heat treatment. Specifically, the metal precursor and the silicon-based precursor and ionic compound may be vaporized from different sources and then mixed, or may be vaporized from the same source to form a mixed gas.

The metal precursor may be vaporized by heat treatment under conditions of 1000°C or higher and 1400°C or lower.

The metal precursor may be a Li precursor or an Mg precursor.

The Li precursor may be, for example, Li powder, LiOH, Li₂O, or the like, but is not limited thereto.

The Mg precursor may be, for example, Mg powder, but is not limited thereto.

The silicon-based particle formed by additionally including a Li precursor or an Mg precursor, performing heat treatment, and then vapor-depositing the mixed gas may further include one or more of a Li compound and an Mg compound, and the Li or Mg may be distributed on the surface of and/or inside the silicon-based particle in the form of being doped into the silicon-based particle.

In another exemplary embodiment, in order to dope the silicon-based particle with metal (for example, Li or Mg), the silicon-based particle and a metal precursor may be mixed and then heat-treated after heat-treating the silicon-based particle and the carbon source. If necessary, the step may be performed under heat treatment or may be performed using an electrochemical method.

The step of mixing the silicon-based particle and the metal precursor and then heat-treating the same may be performed in an inert atmosphere.

The step of mixing the formed silicon-based oxide and the metal precursor and then heat-treating the same may be performed at 400°C to 1400°C, 500°C to 1000°C, or 700°C to 900°C in an inert atmosphere. In addition, after the heat treatment, additional heat treatment may be performed, and the additional heat treatment may be performed at 700°C to 1100°C or 800°C to 1000°C.

In an exemplary embodiment of the present invention, in order to form a carbon layer on the silicon-based particle, a step of heat treating the silicon-based particle and a carbon source may be performed.

The carbon source may be a hydrocarbon gas, but is not limited thereto, and materials known in the art may be appropriately employed.

In the step of heat treating the silicon-based particle and the carbon source, a carbon layer may be formed on the silicon-based particle by using a chemical vapor deposition (CVD) or a method of carbonizing a material serving as the carbon source.

The step of heat treating the silicon-based particle and the carbon source may be performed at 800°C to 1200°C.

Specifically, the carbon layer may be formed by putting the formed silicon-based particle into a reactor, and then depositing a carbon source, for example, a hydrocarbon gas at 600°C to 1200°C by chemical vapor deposition (CVD). The hydrocarbon gas may be at least one hydrocarbon gas selected from the group consisting of methane, ethane, propane and acetylene, and may be preferably heat-treated at 800°C to 1000°C.

In this case, in the process of heat treating the carbon source, the carbon layer is evenly arranged over a large area on the surface of the silicon-based particle and/or inside the pores, thereby improving the conductivity of the negative electrode active material.

The particle size of the silicon-based particle may be adjusted through a method such as a ball mill, a jet mill, or air classification, but the present invention is not limited thereto.

In an exemplary embodiment of the present invention, an average diameter of the pores included in the silicon-based particle may be 20 nm or greater and 60 nm or less.

### <Negative Electrode Active Material>

An exemplary embodiment of the present invention provides a negative electrode active material manufactured by the method for manufacturing a negative electrode active material.

An exemplary embodiment of the present invention provides a negative electrode active material including: a silicon-based particle including SiOₓ(0<x<2) and pores; and a carbon layer provided on a surface of the silicon-based particle and in the pores, wherein the negative electrode active material includes one or more alkali metal elements selected from the group consisting of Li, Na, K, Rb, and Cs and one or more halogen elements selected from the group consisting of F, Cl, Br, and I, and wherein when analyzing a cross section of the negative electrode active material, an average diameter of the pores is 20 nm to 60 nm.

Generally, when forming a carbon layer in order to improve the conductivity of a negative electrode active material, the carbon layer is intensively coated only on the surface of the negative electrode active material, so the conductivity of the negative electrode active material is not sufficiently exhibited, leading to a problem of deterioration in battery characteristics.

On the other hand, the negative electrode active material according to the present invention uses the ionic compound when manufacturing the negative electrode active material, so a large number of pores that satisfy a specific size are formed in the silicon-based particles, thereby enabling the carbon layer to be effectively arranged in the pores of the silicon-based particle to increase the carbon coating area. In addition, the electrical conductivity of the material can be improved by elements derived from the ionic compound remaining inside the negative electrode active material.

In the present specification, providing a carbon layer on a surface of a silicon-based particle means that the carbon layer is arranged on an outer surface of the particle, excluding pores of the silicon-based particle.

In the present specification, providing a carbon layer in the pores of silicon-based particle means that the carbon layer is arranged on surfaces and/or in internal spaces of the pores included in the silicon-based particle.

A negative electrode active material according to an exemplary embodiment of the present invention includes a silicon-based particle including SiOₓ(0<x<2) and pores.

The SiOx (0<x<2) corresponds to a matrix in the silicon-based composite particle. The SiOₓ(0<x<2) may be a form of including Si and/or SiO₂, and the Si may form a phase. That is, x corresponds to a ratio of the number of O to Si included in the SiOₓ(0<x<2). When the silicon-based composite particle includes the SiOₓ (0<x<2), a discharge capacity of a secondary battery can be improved.

In an exemplary embodiment of the present invention, when analyzing a cross section of the negative electrode active material, an average diameter of the pores may be 20 nm to 60 nm, and specifically, 22 nm to 58 nm, 24 nm to 55 nm, or 30 nm to 50 nm.

In the present invention, the cross-sectional analysis of the negative electrode active material may be performed using an ion milling device. Specifically, an electrode sample prepared by coating a negative electrode active material on a copper foil (Cu foil) is milled using a Hitachi IM4000 device. Specifically, each sample may be irradiated with an ion beam at a voltage of 1.5 kV for about 3 to 4 hours, and then a cross-sectional image may be measured with a Hitachi S-4800 SEM. Based on the measured SEM cross-sectional image, the average diameter of pores appearing in the cross-section of the negative electrode active material may be obtained.

The diameter of pores obtained through the aforementioned cross-sectional analysis is related to the diameter of pores located inside the negative electrode active material, and is different from the diameter of pores near the surface of the negative electrode active material measured by the nitrogen adsorption method.

If the average diameter of the pores is less than 20 nm, it is difficult for the pores to accommodate an excessive change in the volume of the silicon-based particle, and particle breakage is observed during long-term cycle behavior, resulting in a rapid decrease in capacity of the battery. When the average diameter of the pores exceeds 60 nm, cell resistance increases due to a small amount of coating of the carbon layer, and a side reaction between an electrolyte solution and the silicon-based particle increases, thereby deteriorating the life characteristics of the battery.

When the carbon layer is formed inside the pores, the average diameter of the pores can be calculated from the diameter of the pores including the carbon layer.

In an exemplary embodiment of the present invention, the silicon-based particle may include one or more of a Li compound and an Mg compound.

In an exemplary embodiment of the present invention, the silicon-based particle may further include a Li compound.

The Li compound may correspond to a matrix in the silicon-based particle. The Li compound may be present in the form of at least one of a lithium atom, lithium silicate, lithium silicide and a lithium oxide in the silicon-based particle. When the silicon-based particle includes a Li compound, the initial efficiency is improved.

The Li compound may be distributed on the surface and/or in the inside of the silicon-based particle in the form of being doped to the silicon-based particle. The Li compound may be distributed on the surface and/or in the inside of the silicon-based particle to serve to control volume expansion/contraction of the silicon-based particle to an appropriate level and to prevent damage to the active material. In addition, the Li compound may be contained, in terms of lowering a ratio of an irreversible phase (for example, SiO₂) of silicon-based particle to increase the efficiency of the negative electrode active material.

In an exemplary embodiment of the present invention, the Li compound may be present in a form of lithium silicate. The lithium silicate is represented by LiₐSi_{b}O_{c} (2≤a≤4, 0<b≤2, 2≤c≤5) and may be divided into crystalline lithium silicate and amorphous lithium silicate. The crystalline lithium silicate may be present in the silicon-based particles in a form of at least one lithium silicate selected from the group consisting of Li₂SiO₃, Li₄SiO₄and Li₂Si₂O₅, and the amorphous lithium silicate may have a complex form of LiₐSi_{b}O_{c} (2≤a≤4, 0<b≤2, 2≤c≤5). However, the present invention is not limited thereto.

In another exemplary embodiment, the Li silicide may include Li₇Si₂, and the Li oxide may include Li₂O.

In an exemplary embodiment of the present invention, Li may be included in an amount of 0.1 part by weight to 40 parts by weight, or 0.1 part by weight to 25 parts by weight, on the basis of 100 parts by weight of the total of the negative electrode active material. Specifically, Li may be included in an amount of 1 part by weight to 25 parts by weight, and more specifically 2 parts by weight to 20 parts by weight, or 2 parts by weight to 10 parts by weight. As the Li content increases, the initial efficiency increases, but the discharge capacity decreases. Therefore, when the above range is satisfied, appropriate discharge capacity and initial efficiency can be implemented.

In an exemplary embodiment of the present invention, the silicon-based particle may further include a Mg compound.

The Mg compound may correspond to a matrix in the silicon-based particle. The Mg compound may be present in the form of at least one of a magnesium atom, magnesium silicate, magnesium silicide and a magnesium oxide in the silicon-based particle. When the silicon-based particle includes a Mg compound, the initial efficiency is improved.

The Mg compound may be distributed on the surface of and/or inside the silicon-based particle in the form of being doped to the silicon-based particle. The Mg compound may be distributed on the surface of and/or inside the silicon-based particle to serve to control volume expansion/contraction of the silicon-based particle to an appropriate level and to prevent damage to the active material. In addition, the Mg compound may be contained, in terms of lowering a ratio of an irreversible phase (for example, SiO₂) of silicon-based particle to increase the efficiency of the negative electrode active material.

In an exemplary embodiment of the present invention, the Mg compound may be present in the form of magnesium silicate. The magnesium silicate may be divided into crystalline magnesium silicate and amorphous magnesium silicate. The magnesium silicate may include at least one of Mg₂SiO₄ and MgSiO₃.
In another exemplary embodiment, the magnesium silicide may include Mg₂Si, and the magnesium oxide may include MgO.

The contents of the Li element and Mg element can be confirmed through inductively coupled plasma (ICP) analysis. Specifically, a predetermined amount (about 0.01 g) of a negative electrode active material is precisely aliquoted, transferred to a platinum crucible, and completely decomposed on a hot plate by adding nitric acid, hydrofluoric acid and sulfuric acid thereto. Then, by using an inductively coupled plasma atomic emission spectrometer (ICP-AES, Perkin-Elmer 7300), a reference calibration curve is obtained by measuring the intensity of a standard liquid, which has been prepared using a standard solution (5 mg/kg), at an intrinsic wavelength of an element to be analyzed. Subsequently, a pre-treated sample solution and a blank sample are introduced into the spectrometer, and by measuring the intensity of each component to calculate an actual intensity, calculating the concentration of each component based on the obtained calibration curve, and performing a conversion such that the sum of the calculated concentrations of the components is equal to a theoretical value, the element content of the prepared negative electrode active material can be analyzed.

In an exemplary embodiment of the present invention, the silicon-based particle may include a further metal atom. The metal atom may be present in the form of at least one of a metal atom, a metal silicate, a metal silicide and a metal oxide in the silicon-based particle. The metal atom may include at least one selected from the group consisting of Mg, Li, Al and Ca. Accordingly, initial efficiency of the negative electrode active material may be improved.

In an exemplary embodiment of the present invention, the carbon layer may be provided on the surface of and in the pores of the silicon-based particle. Accordingly, conductivity is imparted to the silicon-based particle, and volume change of the negative electrode active material including the silicon-based particle is effectively suppressed, thereby improving life characteristics of the battery.

In this case, the carbon layer may cover at least a part of the surface of and the inside of the pores of the silicon-based particle, that is, may partially cover the surface of the particle and the inside of the pores, or may entirely cover the surface of the particle and the inside of the pores.

In an exemplary embodiment of the present invention, the carbon layer includes amorphous carbon.

Further, the carbon layer may further include crystalline carbon.

The crystalline carbon may further improve conductivity of the negative electrode active material. The crystalline carbon may include at least one selected from the group consisting of fullerene, carbon nanotubes, and graphene.

The amorphous carbon may appropriately maintain the strength of the carbon layer to suppress expansion of the silicon-based particle. The amorphous carbon may be a carbide of at least one substance selected from the group consisting of tar, pitch, and other organic materials, or may be a carbon-based material formed by using a hydrocarbon as a source of chemical vapor deposition.

The carbide of the other organic materials may be a carbide of an organic material selected from sucrose, glucose, galactose, fructose, lactose, mannose, ribose, aldohexose or ketohexose carbide, and combinations thereof.

The hydrocarbon may be a substituted or unsubstituted aliphatic or alicyclic hydrocarbon or a substituted or unsubstituted aromatic hydrocarbon. The aliphatic or alicyclic hydrocarbon of the substituted or unsubstituted aliphatic or alicyclic hydrocarbon may be methane, ethane, ethylene, acetylene, propane, butane, butene, pentane, isobutane, hexane or the like. The aromatic hydrocarbon of the substituted or unsubstituted aromatic hydrocarbon may be benzene, toluene, xylene, styrene, ethylbenzene, diphenylmethane, naphthalene, phenol, cresol, nitrobenzene, chlorobenzene, indene, coumarone, pyridine, anthracene, phenanthrene, or the like.

In an exemplary embodiment of the present invention, the carbon layer may be an amorphous carbon layer.

In an exemplary embodiment of the present invention, the carbon layer may be included in an amount of 0.1 part by weight to 50 parts by weight, 0.1 part by weight to 30 parts by weight, or 0.1 part by weight to 20 parts by weight on the basis of 100 parts by weight of the total of the negative electrode active material. More specifically, the carbon layer may be included in an amount of 0.5 part by weight to 15 parts by weight, 1 part by weight to 10 parts by weight, or 1 part by weight to 5 parts by weight. When the above range is satisfied, reduction in capacity and efficiency of the negative electrode active material can be prevented.

In an exemplary embodiment of the present invention, a thickness of the carbon layer may be 1 nm to 500 nm, and specifically 5 nm to 300 nm. When the above range is satisfied, the conductivity of the negative electrode active material is improved, the change in volume of the negative electrode active material is easily suppressed, and the side reaction between the electrolyte solution and the negative electrode active material is suppressed, thereby improving the initial efficiency and/or life of the battery.

Specifically, the carbon layer may be formed by chemical vapor deposition (CVD) using at least one hydrocarbon gas selected from the group consisting of methane, ethane and acetylene.

In an exemplary embodiment of the present invention, the negative electrode active material includes one or more alkali metal elements selected from the group consisting of Li, Na, K, Rb, and Cs, and one or more halogen elements selected from the group consisting of F, Cl, Br, and I. Specifically, when manufacturing the negative electrode active material, a silicon-based particle is manufactured by depositing both a silicon-based precursor and an ionic compound including the alkali metal element and the halogen element. In this case, pores are evenly formed in the silicon-based particle due to the ionic compound, and the silicon-based particle may include the alkali metal element and the halogen element.

In one example, the alkali metal element and the halogen element may be located inside the pores of the negative electrode active material.

In an exemplary embodiment of the present invention, the alkali metal element may be included in an amount of 0.01 part by weight or more and less than 10 parts by weight on the basis of 100 parts by weight of the negative electrode active material. Specifically, the alkali metal element may be included in an amount of more than 0.01 part by weight and less than 10 parts by weight, 0.01 part by weight or more and 5 parts by weight or less, 0.05 part by weight or more and 5 parts by weight or less, 0.05 part by weight or more and 2.5 parts by weight or less, 0.05 part by weight or more and 2 parts by weight or less, or 0.1 part by weight or more and 1.5 parts by weight or less on the basis of 100 parts by weight of the negative electrode active material. In this case, the content of the alkali metal element may mean the content of the alkali metal element derived from the ionic compound.

In an exemplary embodiment of the present invention, the halogen element may be included in an amount of 0.01 part by weight or more and less than 10 parts by weight on the basis of 100 parts by weight of the negative electrode active material. Specifically, the halogen element may be included in an amount of more than 0.01 part by weight and less than 10 parts by weight, 0.01 part by weight or more and 5 parts by weight or less, 0.05 part by weight or more and 5 parts by weight or less, 0.05 part by weight or more and 2.5 parts by weight or less, 0.05 part by weight or more and 2 parts by weight or less, or 0.1 part by weight or more and 1.5 parts by weight or less on the basis of 100 parts by weight of the negative electrode active material. In this case, the content of the halogen element may mean the content of the halogen element derived from the ionic compound.

When the alkali metal element and the halogen element are present in the aforementioned contents in the negative electrode active material, a large number of pores are formed in the silicon-based particle, and the carbon layer is effectively arranged in the pores of the silicon-based particle, thereby increasing the carbon coating area.

On the other hand, if the alkali metal element and the halogen element are not present in the negative electrode active material, i.e., if the ionic compound is not added when manufacturing the silicon-based particle, pores are not formed in the silicon-based particle, so the carbon coating area is reduced, and carbon is intensively coated only on the surface of the silicon-based particle, thereby reducing the conductivity of the negative electrode active material and deteriorating the battery characteristics.

In addition, if the alkali metal element and the halogen element are present in amounts exceeding the above content ranges, the number of pores is small and the average particle diameter is formed to be small, so the carbon layer is not appropriately arranged, reducing the energy density of the battery and deteriorating the discharge capacity, efficiency, and/or life characteristics of the battery during cycle behaviors.

In an exemplary embodiment of the present invention, when the alkali metal element and the halogen element are present in the aforementioned contents in the negative electrode active material, the electrical conductivity of the negative electrode active material can be further improved.

In an exemplary embodiment of the present invention, the negative electrode active material may include Li, Na or K. Specifically, the negative electrode active material may include at least one alkali metal element of Li and Na.

In an exemplary embodiment of the present invention, the negative electrode active material may include F or Cl. Specifically, the negative electrode active material may include at least one halogen element of F and Cl. More specifically, the negative electrode active material may include Cl.

In an exemplary embodiment of the present invention, the negative electrode active material includes an ionic compound. When manufacturing the negative electrode active material, the silicon-based precursor and the ionic compound are deposited together to manufacture the silicon-based particle. At this time, pores can be formed evenly in the silicon-based particle due to the ionic compound.

In one example, the ionic compound may be located inside the pores of the negative electrode active material.

The ionic compound includes one or more alkali metal elements selected from the group consisting of Li, Na, K, Rb, and Cs and one or more halogen elements selected from the group consisting of F, Cl, Br, and I. Specifically, the ionic compound may exist by ionic bonding of the alkali metal element in the form of a cation and the halogen element in the form of an anion.

In an exemplary embodiment of the present invention, the ionic compound may be one or more selected from the group consisting of LiF, LiCl, NaF, and NaCl.

The ionic compound may have a melting point of 600°C to 800°C and a boiling point of 1300°C to 1700°C.

In this case, the ionic compound is removed to form pores during the heat treatment of the silicon-based particle, and part of the ionic compound that has not been removed remains and is present in the negative electrode active material.

The ionic compound may be included in an amount of more than 0 part by weight and less than 10 parts by weight on the basis of 100 parts by weight of the negative electrode active material. Specifically, the content may be more than 0 part by weight and 5 parts by weight or less, 0.1 part by weight or more and 4 parts by weight or less, or 0.1 part by weight or more and 3 parts by weight or less.

When the ionic compound is present in the aforementioned contents in the negative electrode active material, a large number of pores are formed in the silicon-based particle, and the carbon layer is effectively arranged in the pores of the silicon-based particle, thereby increasing the carbon coating area.

On the other hand, if the ionic compound is not present, that is, if the ionic compound is not added when manufacturing the silicon-based particle, pores are not formed in the silicon-based particle, so the carbon coating area is reduced, and carbon is intensively coated only on the surface of the silicon-based particle, thereby reducing the conductivity of the negative electrode active material and deteriorating the battery characteristics. If the ionic compound is present in an amount exceeding the above content range, the number of pores is small and the average particle diameter is formed to be small, so the carbon layer is not appropriately arranged, reducing the energy density of the battery.

In addition, when the ionic compound is present in the above content in the negative electrode active material, the electrical conductivity of the negative electrode active material can be further improved.

An average particle diameter (D₅₀) of the negative electrode active material may be 0.1 µm to 30 µm, specifically 1 µm to 20 µm, and more specifically 1 µm to 10 µm. When the above range is satisfied, the structural stability of the active material is ensured during charging and discharging, a problem that a level of volume expansion/contraction increases as the particle diameter becomes excessively large can be prevented, and a problem that the initial efficiency is reduced as the particle diameter becomes excessively small can also be prevented.

The BET specific surface area of the negative electrode active material may be 1 m²/g to 100 m²/g, specifically, 1 m²/g to 70 m²/g, and more specifically, 1 m²/g to 50 m²/g, for example, 2 m²/g to 30 m²/g. When the above range is satisfied, side reactions between the electrolyte solution and the negative electrode active material can be reduced during charging and discharging of the battery, and thus the life characteristics of the battery can be improved.

### <Negative Electrode>

A negative electrode according to an exemplary embodiment of the present invention may include the negative electrode active material described above.

Specifically, the negative electrode may include a negative electrode current collector and a negative electrode active material layer arranged on the negative electrode current collector. The negative electrode active material layer may include the negative electrode active material. Furthermore, the negative electrode active material layer may further include a binder a thickener and/or a conductive material.

The negative electrode active material layer may be formed by applying a negative electrode slurry including a negative electrode active material, a binder, a thickener, and/or a conductive material to at least one surface of a current collector, and drying and roll-pressing the same.

The negative electrode slurry may further include an additional negative electrode active material.

As the additional negative electrode active material, a compound capable of reversible intercalation and deintercalation of lithium may be used. Specific examples include a carbonaceous material such as artificial graphite, natural graphite, graphitized carbon fiber, and amorphous carbon; a metallic substance capable of being alloyed with lithium, such as Si, Al, Sn, Pb, Zn, Bi, In, Mg, Ga, Cd, Si alloys, Sn alloys, or Al alloys; metallic oxides capable of doping and undoping lithium, such as SiO_{β}(0<β<2), SnO₂, vanadium oxide, lithium titanium oxide, and lithium vanadium oxide; or a composite including the metallic substance and the carbonaceous material, such as a Si-C composite or a Sn-C composite, and any one thereof or a mixture of two or more thereof may be used. In addition, a metal lithium thin film may be used as the negative electrode active material. In addition, both low-crystalline carbon and high-crystalline carbon may be used as the carbon material. Representative examples of the low-crystalline carbon include soft carbon and hard carbon, and representative examples of the high-crystalline carbon include amorphous, platy, scaly, spherical or fibrous natural graphite or artificial graphite, kish graphite, pyrolytic carbon, mesophase pitch based carbon fiber, meso-carbon microbeads, mesophase pitches, and high-temperature fired carbon such as petroleum- or coal tar pitch-derived cokes.

The additional negative electrode active material may be a carbon-based negative electrode active material.

The negative electrode slurry may include a solvent for negative electrode slurry formation. Specifically, the solvent for negative electrode slurry formation may include at least one selected from the group consisting of distilled water, ethanol, methanol, and isopropyl alcohol, and specifically, distilled water, in terms of facilitating dispersion of components.

The negative electrode slurry including the negative electrode active material according to an exemplary embodiment of the present invention may have pH of 7 to 11 at 25°C. When pH of the negative electrode slurry satisfies the above range, the rheological properties of the slurry are stabilized. On the other hand, when pH of the negative electrode slurry is less than 7 or pH of the negative electrode slurry exceeds 11, carboxymethylcellulose (CMC) used as a thickener is decomposed, resulting in lowering in viscosity of the slurry and a decrease in dispersion degree of the active material included in the slurry.

The negative electrode current collector is not particularly limited as long as it has conductivity without causing a chemical change in the battery. For example, for the current collector, copper, stainless steel, aluminum, nickel, titanium, fired carbon, aluminum or stainless steel each surface-treated with carbon, nickel, titanium, silver, or the like, or the like may be used. Specifically, transition metals that adsorb carbon well, such as copper and nickel, may be used for the current collector. A thickness of the current collector may be 6 µm to 20 µm. However, the thickness of the current collector is not limited thereto.

The binder may include at least one selected from the group consisting of polyvinylidenefluoride-hexafluoropropylene copolymer (PVDF-co-HFP), polyvinylidenefluoride, polyacrylonitrile, polymethylmethacrylate, polyvinyl alcohol, carboxymethylcellulose (CMC), starch, hydroxypropylcellulose, regenerated cellulose, polyvinylpyrrolidone, polytetrafluoroethylene, polyethylene, polypropylene, polyacrylic acid, ethylene-propylene-diene monomer (EPDM), sulfonated EPDM, styrene butadiene rubber (SBR), fluoro rubber, poly acrylic acid, and the above-mentioned materials in which a hydrogen is substituted with Li, Na, Ca, etc., and may also include various copolymers thereof.

The conductive material is not particularly limited as long as it has conductivity without causing a chemical change in the battery, and for example, graphite such as natural graphite or artificial graphite; carbon black such as acetylene black, Ketjen black, channel black, furnace black, lamp black, and thermal black; a conductive fiber such as a carbon fiber and a metal fiber; a conductive tube such as a carbon nanotube; metal powders such as fluorocarbon, aluminum, and nickel powder; a conductive whisker such as zinc oxide and potassium titanate; a conductive metal oxide such as titanium oxide; a conductive material such as polyphenylene derivative, and the like may be used.

The thickener may be carboxymethylcellulose (CMC), but is not limited thereto, and thickeners used in the art may be appropriately adopted.

In an exemplary embodiment of the present invention, a weight ratio of the negative electrode active material and the additional negative electrode active material included in the negative electrode slurry may be 1:99 to 30:70, and specifically 5:95 to 30:70 or 10:90 to 20:80.

In an exemplary embodiment of the present invention, the entire negative electrode active materials included in the negative electrode slurry may be included in an amount of 60 parts by weight to 99 parts by weight, and specifically 70 parts by weight to 98 parts by weight on the basis of 100 parts by weight of a total of solid content of the negative electrode slurry.

In an exemplary embodiment of the present invention, the binder may be included in an amount of 0.5 part by weight to 30 parts by weight, and specifically 1 part by weight to 20 parts by weight, on the basis of 100 parts by weight of the total of the solid content of the negative electrode slurry.

In an exemplary embodiment of the present invention, the conductive material may be included in an amount of 0.5 part by weight to 25 parts by weight, specifically 1 part by weight to 20 parts by weight on the basis of 100 parts by weight of the total of the solid content of the negative electrode slurry.

In an exemplary embodiment of the present invention, the thickener may be included in an amount of 0.5 part by weight to 25 parts by weight, specifically 0.5 part by weight to 20 parts by weight, and more specifically 1 part by weight to 20 parts by weight on the basis of 100 parts by weight of the total of the solid content of the negative electrode slurry.

The negative electrode slurry according to an exemplary embodiment of the present invention may further include a solvent for negative electrode slurry formation. Specifically, the solvent for negative electrode slurry formation may include at least one selected from the group consisting of distilled water, ethanol, methanol, and isopropyl alcohol, and specifically, distilled water, in terms of facilitating dispersion of components.

In an exemplary embodiment of the present invention, a solid content of the negative electrode slurry may be 20 parts by weight to 75 parts by weight, and specifically 30 parts by weight to 70 parts by weight on the basis of a total of 100 parts by weight of the negative electrode slurry.

### <Secondary Battery>

A secondary battery according to an exemplary embodiment of the present invention may include the negative electrode according to an exemplary embodiment of the present invention described above. Specifically, the secondary battery may include a negative electrode, a positive electrode, a separator interposed between the positive electrode and the negative electrode, and an electrolyte solution, and the negative electrode is the same as the negative electrode described above. Since the negative electrode has been described above, a detailed description thereof is omitted.

The positive electrode may include a positive electrode current collector and a positive electrode active material layer formed on the positive electrode current collector and including the positive electrode active material.

In the positive electrode, the positive electrode current collector is not particularly limited as long as it has conductivity without causing a chemical change in the battery. For example, stainless steel, aluminum, nickel, titanium, fired carbon, aluminum or stainless steel each surface-treated with carbon, nickel, titanium, silver, or the like, or the like may be used. In addition, the positive electrode current collector may typically have a thickness of 3 µm to 500 µm, and a surface of the current collector may be formed with microscopic irregularities to enhance adhesive force of the positive electrode active material. For example, the positive electrode current collector may be used in various forms such as a film, a sheet, a foil, a net, a porous body, a foamed body, and a non-woven fabric body.

The positive electrode active material may be a positive electrode active material that is typically used. Specifically, the positive electrode active material may be a layered compound such as a lithium cobalt oxide (LiCoO₂) and a lithium nickel oxide (LiNiO₂), or a compound substituted with one or more transition metals; a lithium iron oxide such as LiFe₃O₄; a lithium manganese oxide such as chemical formula Li_{1+c1}Mn_{2-c1}O₄(0≤c1≤0.33), LiMnO₃, LiMn₂O₃ and LiMnO₂; a lithium copper oxide (Li₂CuO₂); a vanadium oxide such as LiV₃O₈, V₂O₅ and Cu₂V₂O₇; a Ni-site type lithium nickel oxide represented by chemical formula LiNi_{1-c2}M_{c2}O₂ (where M is at least one selected from the group consisting of Co, Mn, Al, Cu, Fe, Mg, B, and Ga, and satisfies 0.01≤c2≤0.3); a lithium manganese composite oxide represented by chemical formula LiMn_{2-c3}M_{c3}O₂ (where M is at least one selected from the group consisting of Co, Ni, Fe, Cr, Zn and Ta, and satisfies 0.01≤c3≤0.1) or Li₂Mn₃MO₈ (where M is at least one selected from the group consisting of Fe, Co, Ni, Cu and Zn); LiMn₂O₄ in which a part of Li of the chemical formula is substituted with an alkaline earth metal ion, or the like, but is not limited thereto. The positive electrode may be Li metal.

The positive electrode active material layer may include a positive electrode conductive material and a positive electrode binder together with the positive electrode active material described above.

In this case, the positive electrode conductive material is used to impart conductivity to the electrode, and can be used without particular limitation as long as the positive electrode conductive material has electronic conductivity without causing a chemical change in a battery to be constituted. Specific examples may include graphite such as natural graphite and artificial graphite; a carbon-based material such as carbon black, acetylene black, Ketjen black, channel black, furnace black, lamp black, thermal black and carbon fiber; metal powders or metal fibers such as copper, nickel, aluminum and silver; a conductive whisker such as zinc oxide and potassium titanate; a conductive metal oxide such as titanium oxide; or a conductive polymer such as polyphenylene derivative, or the like, and any one thereof or a mixture of two or more thereof may be used.

In addition, the positive electrode binder serves to improve bonding between particles of the positive electrode active material and adhesive force between the positive electrode active material and the positive electrode current collector. Specific examples may include polyvinylidenefluoride (PVDF), polyvinylidenefluoride-hexafluoropropylene copolymer (PVDF-co-HFP), polyvinyl alcohol, polyacrylonitrile, carboxymethylcellulose (CMC), starch, hydroxypropylcellulose, regenerated cellulose, polyvinylpyrrolidone, polytetrafluoroethylene, polyethylene, polypropylene, ethylene-propylene-diene monomer (EPDM), sulfonated-EPDM, styrene butadiene rubber (SBR), fluoro rubber, or various copolymers thereof, and the like, and any one thereof or a mixture of two or more thereof may be used.

The separator serves to separate the negative electrode and the positive electrode and to provide a movement path of lithium ions, in which any separator may be used as the separator without particular limitation as long as it is typically used in a secondary battery, and particularly, a separator having high moisture-retention ability for an electrolyte solution as well as a low resistance to the movement of electrolyte solution ions may be preferably used. Specifically, a porous polymer film, for example, a porous polymer film manufactured from a polyolefin-based polymer, such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a usual porous non-woven fabric, for example, a non-woven fabric formed of high melting point glass fibers, polyethylene terephthalate fibers, or the like may be used. Furthermore, a coated separator including a ceramic component or a polymer material may be used to secure heat resistance or mechanical strength, and the separator having a single layer or multilayer structure may be selectively used.

Examples of the electrolyte solution may include an organic liquid electrolyte, an inorganic liquid electrolyte, a solid polymer electrolyte, a gel-type polymer electrolyte, a solid inorganic electrolyte, a molten-type inorganic electrolyte and the like that may be used in the manufacturing of the lithium secondary battery, but are not limited thereto.

Specifically, the electrolyte solution may include a non-aqueous organic solvent and a metal salt.

As the non-aqueous organic solvent, for example, an aprotic organic solvent such as N-methyl-2-pyrrolidinone, propylene carbonate, ethylene carbonate, butylene carbonate, dimethyl carbonate, diethyl carbonate, gamma-butyrolactone, 1,2-dimethoxy ethane, tetrahydrofuran, 2-methyltetrahydrofuran, dimethyl sulfoxide, 1,3-dioxolane, formamide, dimethylformamide, dioxolane, acetonitrile, nitromethane, methyl formate, methyl acetate, phosphoric acid triester, trimethoxy methane, dioxolane derivative, sulfolane, methyl sulfolane, 1,3-dimethyl-2-imidazolidinone, propylene carbonate derivative, tetrahydrofuran derivative, ether, methyl propionate, or ethyl propionate may be used.

In particular, among the carbonate-based organic solvents, ethylene carbonate and propylene carbonate, which are cyclic carbonates, are high-viscosity organic solvents and can be preferably used because they have high permittivity to dissociate a lithium salt well. When the cyclic carbonate is mixed with a linear carbonate with low viscosity and low permittivity, such as dimethyl carbonate or diethyl carbonate, in a suitable ratio and used, an electrolyte solution with high electric conductivity may be prepared, and therefore, may be more preferably used.

A lithium salt may be used as the metal salt, and the lithium salt is a material that is readily soluble in the non-aqueous electrolyte solution, in which, for example, one or more selected from the group consisting of F⁻, Cl⁻, I⁻, NO₃⁻, N(CN)₂⁻, BF₄⁻, ClO₄⁻, PF₆⁻, (CF₃)₂PF₄⁻, (CF₃)₃PF₃⁻, (CF₃)₄PF₂⁻, (CF₃)₅PF⁻, (CF₃)₆P⁻, CF₃SO₃⁻, CF₃CF₂SO₃⁻, (CF₃SO₂)₂N⁻, (FSO₂)₂N⁻, CF₃CF₂(CF₃)₂CO⁻, (CF₃SO₂)₂CH⁻, (SF₅)₃C⁻, (CF₃SO₂)₃C⁻, CF₃(CF₂)₇SO₃⁻, CF₃CO₂⁻, CH₃CO₂⁻, SCN⁻ and (CF₃CF₂SO₂)₂N⁻ may be used as an anion of the lithium salt.

One or more additives, for example, a haloalkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride, may be further included in the electrolyte solution for the purpose of improving life characteristics of the battery, suppressing a decrease in battery capacity, improving discharge capacity of the battery, and the like, in addition to the above-described electrolyte solution components.

Another exemplary embodiment of the present invention provides a battery module including the secondary battery as a unit cell, and a battery pack including the same. Since the battery module and the battery pack include the secondary battery having high capacity, high-rate capability, and high cycle characteristics, the battery module and the battery pack may be used as a power source of a medium to large sized device selected from the group consisting of an electric vehicle, a hybrid electric vehicle, a plug-in hybrid electric vehicle, and a power storage system.

Hereinafter, Examples will be described in detail to specifically describe the present specification. However, the Examples according to the present specification may be modified in other forms, and the scope of the present application is not construed as being limited to the following Examples. The Examples of the present application are provided to more completely explain the present specification to one skilled in the art.

### Mode for Invention

### <Examples and Comparative Examples>

### Example 1

900 g of powders of Si and SiO₂ mixed at a molar ratio of 1:1 and 10 g of an ionic compound (NaCl) were mixed properly and vacuum heated to a sublimation temperature of 2,400°C in a reactor. Then, a mixed gas of vaporized Si, SiO₂, and ionic compound was reacted in a cooling zone in a vacuum state where cooling temperature was 800°C, and condensed into a solid phase. Thereafter, heat treatment was performed at a temperature of 800°C in an inert atmosphere to prepare preliminary silicon-based particles. Then, the preliminary silicon-based particles were pulverized for 3 hours to prepare silicon-based particles having a size of 6 µm (D₅₀) by using 15 sus ball media added for ball mill. Then, the silicon-based particles were positioned in a hot zone of a CVD apparatus while maintaining the inert atmosphere by causing Ar gas to flow, and a reaction was carried out at 10⁻¹ torr for 5 hours while blowing methane into the hot zone of 900°C using Ar as a carrier gas, thereby forming a carbon layer on the surface of the silicon-based particles.

A composition for forming a negative electrode active material was prepared by solid-phase mixing the silicon-based particles with the carbon layer formed thereon and lithium metal powder as a lithium precursor at a weight ratio of 90:10.

The composition for forming a negative electrode active material was heat-treated at 800°C for 3 hours.

The heat-treated composition for forming a negative electrode active material was subjected to acid treatment with an aqueous hydrochloric acid solution whose pH is 1 at 23°C, for 1 hour, whereby a negative electrode active material was prepared.

The Na content of the negative electrode active material was 1.5 wt%, and the Cl content was 1.2 wt%.

### Example 2

A negative electrode active material was prepared in the same manner as in Example 1, except that the heat treatment, which was performed after condensing the mixed gas, was performed at 860°C.

The Na content of the negative electrode active material was 1.3 wt%, and the Cl content was 1.0 wt%.

### Example 3

A negative electrode active material was prepared in the same manner as in Example 1, except that the heat treatment, which was performed after condensing the mixed gas, was performed at 900°C.

The Na content of the negative electrode active material was 0.7 wt%, and the Cl content was 0.7 wt%.

### Example 4

A negative electrode active material was prepared in the same manner as in Example 1, except that the heat treatment, which was performed after condensing the mixed gas, was performed at 1100°C.

The Na content of the negative electrode active material was 0.1 wt%, and the Cl content was 0.1 wt%.

### Example 5

A negative electrode active material was prepared in the same manner as in Example 1, except that LiCl was used instead of NaCl.

The Li content of the negative electrode active material was 6.2 wt%, and the Cl content was 1.5 wt%. In this case, the content of Li derived from the ionic compound was 1.2 wt%, and the content of Li derived from the lithium precursor was 5 wt%.

### Example 6

A negative electrode active material was prepared in the same manner as in Example 1, except that Mg metal powder was used instead of lithium metal powder.

The Na content of the negative electrode active material was 1.4 wt%, and the Cl content was 1.3 wt%.

### Comparative Example 1

A negative electrode active material was prepared in the same manner as in Example 1, except that the ionic compound was not mixed.

### Comparative Example 2

A negative electrode active material was prepared in the same manner as in Example 1, except that the heat treatment, which was performed after condensing the mixed gas, was performed at 700°C.

### Comparative Example 3

A negative electrode active material was prepared in the same manner as in Example 1, except that the heat treatment, which was performed after condensing the mixed gas, was performed at 600°C.

### Comparative Example 4

A negative electrode active material was prepared in the same manner as in Example 1, except that the heat treatment, which was performed after condensing the mixed gas, was performed at 650°C.

### Comparative Example 5

A negative electrode active material was prepared in the same manner as in Example 1, except that the heat treatment, which was performed after condensing the mixed gas, was performed at 500°C.

### Comparative Example 6

A negative electrode active material was prepared in the same manner as in Comparative example 1, except that Mg metal powder was used instead of lithium metal powder.

### <Content analysis of carbon layer>

The content of the carbon layer was analyzed using CS-analyzer (CS-800, ELTRA).

### <Element content analysis>

The element content (wt%) of the negative electrode active material was confirmed through SEM-EDS (JEOL LTD; JSM-7610F) .

A cross section of the negative electrode active material was prepared using an ion milling device. First, an electrode sample prepared by coating a negative electrode active material on a copper foil was milled using a Hitachi IM4000 device. Specifically, each sample was irradiated with an ion beam at a voltage 1.5 kV for about 3 to 4 hours, and then a SEM cross-sectional image was entirely subjected to EDS measurement to measure the element content inside the material.

### <Cross-sectional analysis of negative electrode active material (average diameter measurement)>

Cross-sectional analysis of the negative electrode active material was performed using an ion milling device. First, an electrode sample prepared by coating a negative electrode active material on a copper foil was milled using a Hitachi IM4000 device. Specifically, each sample was irradiated with an ion beam at a voltage 1.5 kV for about 3 to 4 hours, and then a cross-sectional image was measured with a Hitachi S-4800 SEM. Next, the average diameter of pores appearing in the cross section of the negative electrode active material was calculated based on the measured SEM cross-sectional image.

### <Analysis of D₅₀ and specific surface area of negative electrode active material>

D₅₀ of the negative electrode active material was analyzed by laser diffraction particle size analysis using a Microtrac S3500 instrument, and the BET specific surface area of the negative electrode active material was measured using a BET measuring instrument (BEL-SORP-MAX, Nippon Bell).

**[Table 1]**

| | Heat treatment temperature (°C) | Based on total 100 parts by weight of negative electrode active material | | | Average diameter of pores [nm] | D₅₀ (µm) of negative electrode active material | Specific surface area (m²/g) of negative electrode active material |
|---|---|---|---|---|---|---|---|
| | | Content of alkali metal element (part by weight) | Content of halogen element (part by weight) | Carbon layer (part by weight) | | | |
| Example 1 | 800 | Na (1.5) | Cl (1.2) | 5 | 24 | 6 | 7.24 |
| Example 2 | 860 | Na (1.3) | Cl (1.0) | 5.4 | 31 | 5.9 | 7.35 |
| Example 3 | 900 | Na (0.7) | Cl (0.7) | 5.5 | 45 | 6 | 7.6 |
| Example 4 | 1100 | Na (0.1) | Cl (0.1) | 5.7 | 55 | 6 | 8.1 |
| Example 5 | 800 | Li (6.2) | Cl (1.5) | 5 | 25 | 6.1 | 7.21 |
| Example 6 | 800 | Na (1.4) | Cl (1.3) | 5 | 27 | 6 | 7.28 |
| Comparative Example 1 | 800 | - | - | 5 | X | 6.1 | 7.0 |
| Comparative Example 2 | 700 | Na (2.6) | Cl (2.4) | 5 | 15 | 6 | 7.11 |
| Comparative Example 3 | 600 | Na (2.7) | Cl (3.0) | 5 | 15 | 6.1 | 7.0 |
| Comparative Example 4 | 650 | Na (2.6) | Cl (2.7) | 5 | less than 10 | 6.2 | 7.08 |
| Comparative Example 5 | 500 | Na (3.3) | Cl (3.4) | 5 | less than 10 | 6.1 | 6.95 |
| Comparative Example 6 | 800 | - | - | 5 | X | 5.9 | 7.15 |

### <Experimental Example: Conductivity evaluation of negative electrode active material>

The conductivity of the negative electrode active material was measured using a powder resistance measuring device (HPRM-1000, HANTECH CO.). After putting 3 g of sample (negative electrode active material) evenly into a cylindrical mold with a diameter of 20 mm, the resistance was measured every 400 kgf from 400 kgf to 2000 kgf, and the conductivity of the negative electrode active material was relatively evaluated in Table 2 below based on Example 1.

### <Experimental Example: Evaluation of discharge capacity, initial efficiency, and life (capacity retention rate) characteristics>

A negative electrode and a battery were manufactured using the negative electrode active materials of Examples and Comparative Examples, respectively.

A mixture was manufactured by mixing the negative electrode active material, carbon black as a conductive material, and polyacrylic acid (PAA) as a binder in a weight ratio of 80:10:10. Thereafter, 7.8 g of distilled water was added to 5 g of the mixture, which was then evenly mixed to prepare a negative electrode slurry. The negative electrode slurry was applied to a copper (Cu) metal thin film as a negative electrode current collector having a thickness of 15 µm, and dried. At this time, the temperature of the circulating air was 60°C. Then, the thin film was roll-pressed and dried 130°C for 12 hours in a vacuum oven to prepare a negative electrode.

A porous polyethylene separator was interposed between the prepared electrode as a negative electrode and the Li metal thin film cut into a circular shape of 1.7671 cm² as a positive electrode, and an electrolyte solution obtained by dissolving vinylene carbonate to 0.5 part by weight in a mixed solution in which ethyl methyl carbonate (EMC) and ethylene carbonate (EC) were mixed in a volume ratio of 7:3, and dissolving LiPF₆ to a concentration of 1 M was injected to prepare a lithium coin half-cell.

The prepared batteries were charged and discharged to evaluate discharge capacity, initial efficiency, and capacity retention rate, which are shown in Table 2 below.

The charging and discharging were performed at 0.1C for the first cycle and the second cycle, and the charging and discharging were performed at 0.5C from the third cycle to the 49th cycle. The last cycle was terminated in a charge state (in a state in which lithium was contained in the negative electrode).
Charging conditions: CC (constant current)/CV (constant voltage) (5mV/0.005C current cut-off)
Discharging conditions: CC (constant current) condition 1.5V

The discharge capacity (mAh/g) and the initial efficiency (%) were derived from the result after charging and discharging once. Specifically, the initial efficiency (%) was derived by the following calculation. Initial efficiency (%) = (one time discharge capacity/one time charge capacity)×100

The capacity retention rate was derived by the following calculation. Capacity retention rate (%) = (49 times discharge capacity/one time discharge capacity)×100

**[Table 2]**

| Battery | Conductivity (%) of negative electrode active material | Discharge capacity (mAh/g) | Initial efficiency (%) | Capacity retention rate (%) |
|---|---|---|---|---|
| Example 1 | 100 (standard) | 450 | 91. 8 | 90 |
| Example 2 | 109 | 447 | 92.2 | 92 |
| Example 3 | 112 | 445 | 92.5 | 94 |
| Example 4 | 110 | 448 | 92.8 | 95 |
| Example 5 | 100 | 450 | 91.9 | 91 |
| Example 6 | 105 | 457 | 92.5 | 94 |
| Comparative Example 1 | 95 | 450 | 89.9 | 85 |
| Comparative Example 2 | 120 | 442 | 92.4 | 85 |
| Comparative Example 3 | 150 | 440 | 92.5 | 80 |
| Comparative Example 4 | 160 | 437 | 92.8 | 76 |
| Comparative Example 5 | 140 | 431 | 93.1 | 74 |
| Comparative Example 6 | 97 | 450 | 91.2 | 89 |

According to Table 2, in the negative electrode active materials of Examples 1 to 6, which include an alkali metal element and a halogen element and have a pore size of 20 nm to 60 nm, the carbon layer is effectively arranged in the pores of the silicon-based particles, so that the carbon coating area is large, and the electrical conductivity is improved by the ions remaining inside the negative electrode active material. Accordingly, it could be confirmed that the discharge capacity, the efficiency, and/or the life characteristics were improved.

On the other hand, when the negative electrode active material did not include an alkali metal element and a halogen element, as in Comparative Examples 1 and 6, it could be confirmed that pores were not formed and the electrical conductivity was not improved, so the efficiency and/or life characteristics were poor. Even when the active material particles include an alkaline metal such as lithium or an alkali earth metal such as magnesium, as in Comparative Examples 1 and 6, an appropriate pore size of the active material particles cannot be implemented if an ionic compound is not added when preparing the preliminary silicon-based particles.

In Comparative Examples 2 to 5, it could be confirmed that, although the electrical conductivity was improved due to the ionic compound included in an excessive amount in the negative electrode active material, the material capacity decreased due to the ionic compound included in the excessive amount, and the discharge capacity, efficiency, and/or life characteristics of the battery were significantly deteriorated during cycle behaviors.

## Claims

1. A method for manufacturing a negative electrode active material, the method comprising:
vaporizing a silicon-based precursor and an ionic compound by heat treatment;
forming a silicon-based particle by depositing a mixed gas of the silicon-based precursor and the ionic compound together in a gas phase; and
heat treating the silicon-based particle and a carbon source.

2. The method of claim 1, wherein the silicon-based precursor is mixed powder of Si powder, SiO powder, and SiO₂ powder.

3. The method of claim 1, wherein the ionic compound comprises one or more alkali metal elements selected from the group consisting of Li, Na, K, Rb, and Cs and one or more halogen elements selected from the group consisting of F, Cl, Br, and I.

4. The method of claim 1, wherein the ionic compound is one or more selected from the group consisting of LiF, LiCl, NaF, and NaCl.

5. The method of claim 1, wherein the deposition is performed in an inert gas atmosphere and at a temperature of 500°C or higher and 1000°C or lower.

6. The method of claim 1, wherein the heat treatment of the silicon-based particle and the carbon source is performed at 800°C to 1200°C.

7. A negative electrode active material manufactured by the method for manufacturing a negative electrode active material of any one of claims 1 to 6.

8. A negative electrode active material comprising:
a silicon-based particle comprising SiOx (0<x<2) and pores; and
a carbon layer provided on a surface and in the pores of the silicon-based particle,
wherein the negative electrode active material comprises one or more alkali metal elements selected from the group consisting of Li, Na, K, Rb, and Cs, and one or more halogen elements selected from the group consisting of F, Cl, Br, and I, and
wherein when analyzing a cross section of the negative electrode active material, an average diameter of the pores is 20 nm to 60 nm.

9. The negative electrode active material of claim 8, wherein the negative electrode active material comprises at least one alkali metal element of Li and Na.

10. The negative electrode active material of claim 8, wherein the negative electrode active material comprises at least one halogen element of F and Cl.

11. The negative electrode active material of claim 8, wherein the alkali metal element is one or more selected from the group consisting of Na, K, Rb, and Cs, and
wherein the alkali metal element is included in an amount of more than 0.01 part by weight and less than 10 parts by weight on the basis of 100 parts by weight of the negative electrode active material.

12. The negative electrode active material of claim 8, wherein the halogen element is one or more selected from the group consisting of Cl, Br, and I, and
wherein the halogen element is included in an amount of more than 0.01 part by weight and less than 10 parts by weight on the basis of 100 parts by weight of the negative electrode active material.

13. The negative electrode active material of claim 8, wherein the alkali metal element and the halogen metal element are located inside the pores.

14. The negative electrode active material of claim 8, wherein the carbon layer is included in an amount of 0.1 part by weight to 50 parts by weight on the basis of 100 parts by weight of a total of the negative electrode active material.

15. The negative electrode active material of claim 8, wherein the silicon-based particle further comprises a Li compound or an Mg compound.

16. A negative electrode comprising the negative electrode active material of any one of claims 8 to 15.

17. A secondary battery comprising the negative electrode of claim 16.
